Europäisches Patentamt

European Patent Office

Office européen des brevets

(19)

(11) **EP 0 990 162 B1**

(12) **EUROPÄISCHE PATENTSCHRIFT**

(45) Veröffentlichungstag und Bekanntmachung des
Hinweises auf die Patenterteilung:
**30.01.2002 Patentblatt 2002/05**

(21) Anmeldenummer: **98936205.8**

(22) Anmeldetag: **17.06.1998**

(51) Int Cl.⁷: **G01R 29/18**

(86) Internationale Anmeldenummer:
**PCT/DE98/01661**

(87) Internationale Veröffentlichungsnummer:
**WO 98/59253 (30.12.1998 Gazette 1998/52)**

(54) **VERFAHREN ZUR DREHSINNERFASSUNG IN DREHSTROMNETZEN**

METHOD FOR DETECTING THE DIRECTION OF ROTATION IN THREE-PHASE NETWORKS

PROCEDE DE DETECTION DU SENS DE ROTATION DANS DES RESEAUX A COURANT
TRIPHASE

(84) Benannte Vertragsstaaten:
**DE FR GB IT**

(30) Priorität: **20.06.1997 DE 19726231**

(43) Veröffentlichungstag der Anmeldung:
**05.04.2000 Patentblatt 2000/14**

(73) Patentinhaber: **SIEMENS
AKTIENGESELLSCHAFT
80333 München (DE)**

(72) Erfinder:
• **ELSNER, Norbert
D-91088 Bubenreuth (DE)**
• **RUNGGALDIER, Diethard
D-96135 Stegaurach (DE)**

(56) Entgegenhaltungen:
**EP-A- 0 599 648         DE-C- 19 508 769
US-A- 4 278 937**

**Beschreibung**

Die Erfindung bezieht sich auf Verfahren zur Drehsinnerfassung in Drehstromnetzen, bei denen die einzelnen Phasen zu jeweils vorbestimmten Zeitpunkten abgetastet werden, gemäß dem Oberbegriff des Patentanspruches 1 oder dem Oberbegriff des Patentanspruches 2. Solche Verfahren sind aus der EP 0 599 648 A1 bekannt.

Die Drehsinnerfassung in Drehstromnetzen erfolgt bisher häufig nach empirischen Methoden. In der Praxis besteht das Bedürfnis, insbesondere bei Motorsteuerschaltungen bereits vorhandene Überlastrelais mit zusätzlichen Funktionen zur Betriebsüberwachung auszustatten. Eine derartige Zusatzfunktion kann beim Einsatz des Überlastrelais in Drehstromnetzen vorteilhafterweise die Drehsinnerfassung sein, um Störfälle beispielsweise bei Installations- sowie Umbauarbeiten zu vermeiden.

Aus etz-b, 29 (1977), Seite 602 ist ein elektronischer Drehfeldanzeiger bekannt, bei dem zur Bestimmung des Drehsinnes eine Impulsfolge gebildet wird und aus der Impulsfolge Aussagen über "Linkslauf" oder "Rechtslauf" des Drehfeldes abgeleitet werden. Weiterhin ist aus JP 55-13868 A2 ein sogenannter "Antiphase Detector" bekannt, bei dem eine Halbwellengleichrichtung vorgenommen wird. Aus der JP 55-114963 A2 ist schließlich ein Phasendetektor bekannt, bei dem alle Phasen gleichzeitig zu mehreren Zeitpunkten abgetastet werden müssen.

Vom weiteren Stand der Technik zeigt die DE 195 25 761 A1 eine Synronisations-Erfassungsschaltung mit einem Mustervergleicher. Daneben beschreibt die EP 0 440 782 B1 ein Auslösesystem zum Unterbrechen wenigstens einer Anzahl von Stromwegen eines mehrphasigen Netzwerkes, welches einen Mikrocomputer aufweist.

Aus der eingangs bereits erwähnten EP 0 599 648 A1 wird im einzelnen ein Dreiphasen-Leistungsanalysator beschrieben, bei dem digitale Werte der Signale in den drei Phasen gespeichert werden und ausgehend von einem Nullpunkt die positiven, negativen und weitere Signalfolgen erfaßt werden. Daneben ist aus der US 4 278 937 A eine Schaltungsanordnung bekannt, in der die Phasenfolge eines Drehfeldes durch Spannungsvergleiche der einzelnen Halbwellen erfolgt. Schließlich wird in der DE 195 08 769 C1 ein Verfahren zur Bestimmung des Drehsinns eines Drehstromnetzes und eine Schaltungsanordnung zur Durchführung des Verfahrens beschrieben, bei denen die Ermittlung des Nulldurchganges einer Phase bei gleichzeitiger Erfassung der Polarität der beiden übrigen Phasen vorgesehen ist. In Relation zum Nullpunkt kann durch den Vergleich der Polaritäten mit einem Mikroprozessor die Drehrichtung bestimmt werden. Das Erfassen des Nulldurchganges ist dabei jeweils vergleichsweise aufwendig.

Ausgehend vom Stand der Technik ist es Aufgabe der Erfindung, einfache und automatisierbare Verfahren zur Drehsinnerfassung in Drehstromnetzen vorzuschlagen und zugehörige Anwendungen anzugeben.

Die Aufgabe ist erfindungsgemäß alternativ durch die Maßnahmen des Patentanspruches 1 oder die Maßnahmen des Patentanspruches 2 gelöst. In erster Alternative, bei der die einzelnen Phasen alternierend in vorgegebenen Zeitabständen abgetastet und durch einen vorgegebenen Auswertealgorithmus ausgewertet werden, wird durch den Auswertealgorithmus eine Ergebnisgröße definiert, wobei das Vorzeichen der Ergebnisgröße, die aus den in wenigstens zwei Zeitpunkten abgetasteten Meßwerten der einzelnen Phasen ermittelt wird, signifikant für "Linkslauf" oder "Rechtslauf" des Drehstromes ist. In zweiter Alternative, bei der die einzelnen Phasen in vorgegebenen Zeitabständen abgetastet und durch einen vorgegebenen Auswertealgorithmus ausgewertet werden, beschreibt der Auswertealgorithmus ein Muster der Vorzeichen der Meßwerte, die durch Abtastung in wenigstens zwei Zeitpunkten erhalten werden, und wird aus der Gesamtheit der Vorzeichenänderungen der Meßwerte der einzelnen Phasen eine eindeutige Aussage "Linkslauf" oder "Rechtslauf" abgeleitet.

Bei der Erfindung ist vorteilhaft, daß die einzelnen Phasen alternierend oder alle drei Phasen innerhalb eines kurzen Meßzeitintervalles in vorgegebenen Zeitabständen abgetastet werden. Das Meßzeitintervall kann beispielsweise 100 μs betragen. Insbesondere in einem dreiphasigen Netz kann die Abtastfrequenz etwa dem Dreifachen der Netzfrequenz entsprechen.

Bei der Erfindung kann insbesondere bei idealem Sinusverlauf ein einziger Auswertezyklus hinreichend sein. Ein derartiger Auswertezyklus besteht aus wenigstens drei Meßpunkten.

Bei der einer vorteilhaften Realisierung der ersten erfindungsgemäßen Lösung werden gleichgerichtete Signalverläufe der einzelnen Phasen ausgewertet. Dabei können die einzelnen Phasen einweg- oder zweiweggleichgerichtet sein.

In vorzugsweiser Anwendung werden die erfindungsgemäßen Verfahren speziell zur Drehsinnerfassung mit einem digitalen Überlastrelais genutzt. Dabei ist besonders vorteilhaft, daß zur Überwachung des Drehsinns eine dort bereits vorhandene digitale Signalsteuerung und/oder Signalverarbeitung genutzt werden kann.

Insbesondere für letzteren Anwendungsfall der Erfindung kann der Drehsinn in 50 Hz- und/oder 60 Hz-Netzen in einfacher Weise aus einweggleichgerichteten Drehstromsignalen bestimmt werden. Dies ist deshalb von Bedeutung, da der üblicherweise vorhandene Analogteil der Signalerfassung in Überstromrelais nur positive Signale verarbeiten kann.

Weitere Einzelheiten und Vorteile der Erfindung ergeben sich aus der nachfolgenden Figurenbeschreibung eines Ausführungsbeispiels anhand der Zeichnung in Verbindung mit den Patentansprüchen. Es zeigen

| Figur 1a bis 1c | das Prinzip der Drehsinnerfassung im Drehstromnetz, |
|---|---|
| Figur 2 | den Verlauf der drei Phasen mit idealen Sinusspannungen über einen Auswertezyklus und einer zugehörigen Ergebnisgröße zur Richtungsidentifikation des Drehsinns, |
| Figur 3 | die Interpolation bzw. Berechnung der Näherungswerte für die Phasen L2 und L3 eines Drehstromnetzes und |
| Figur 4 | den Verlauf von einweggleichgerichteten Drehstromsignalen zur Auswertung des Drehsinns mit der zugehörigen Ergebnisgröße. |

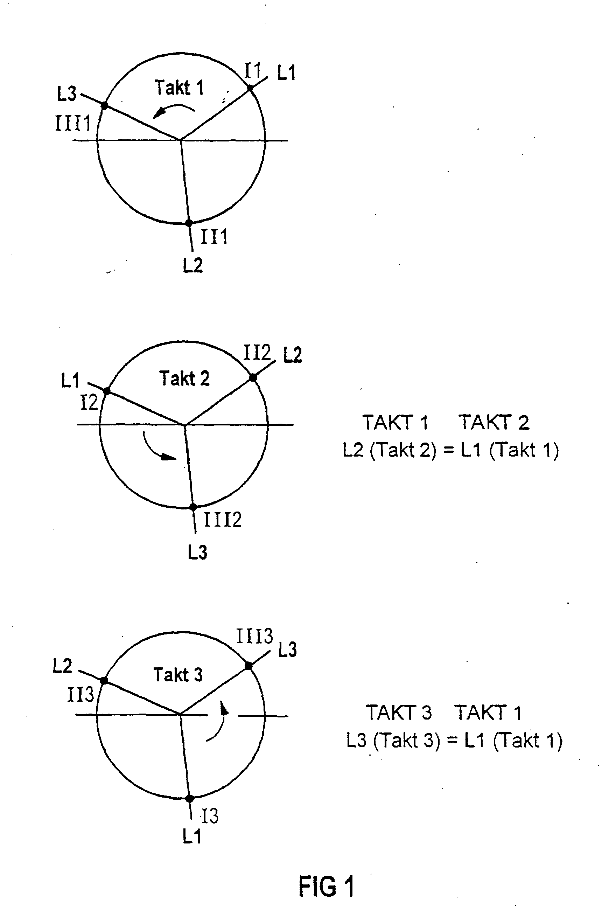

Aus Figur 1 ist den Zeigerdiagrammen zu drei aufeinanderfolgenden Meßtakten I, II und III einer Drehsinnerfassung im Drehstromnetz entnehmbar. Im Beispiel ist ein Rechtslauf dargestellt, bei dem die Taktfrequenz das 3fache der Netzfrequenz ist. Im einzelnen geht es darum, bei den entsprechenden Takten die Meßwerte in geeigneter Form auszuwerten.

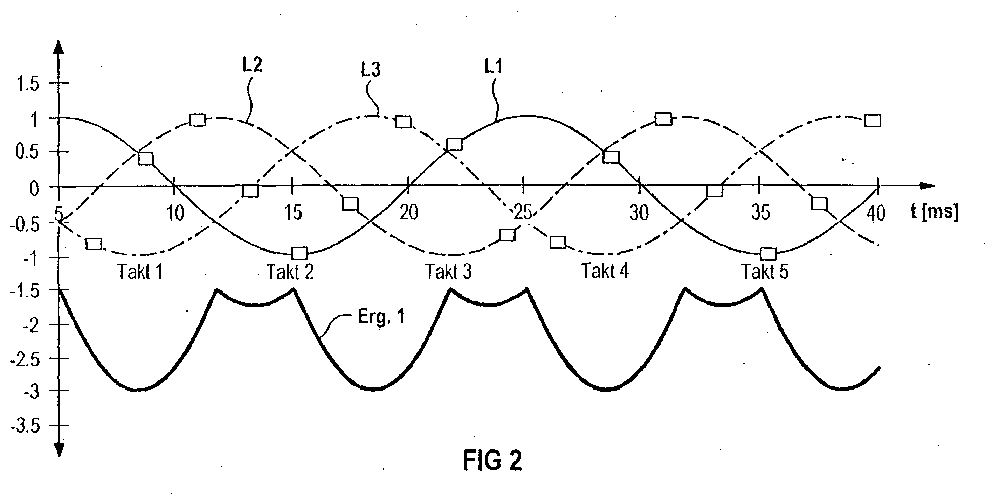

Gemäß Figur 2 benutzt das Grundverfahren der erfindungsgemäßen Drehsinnerkennung einen einzigen Auswertezyklus, bei dem die Analogwerte der Drehstromsignale mit einer Taktfrequenz, die der dreifachen Netzfrequenz entspricht, gemessen werden. Bei Takt I wird das Analogsignal der Referenzphase L1 gemessen, bei den Takten II und III werden jeweils beide Analogsignale von Phase L2 und L3 gemessen. Ist der Ergebniswert eines Auswertezyklus negativ, so ist der Drehsinn im Drehstromnetz rechtsgerichtet. Bei positivem Ergebnis ist der Drehsinn entsprechend linksgerichtet. Der Absolutwert des Ergebniswertes liegt zwischen $1,5*U_{Strang}$ und $3*U_{Strang}$.

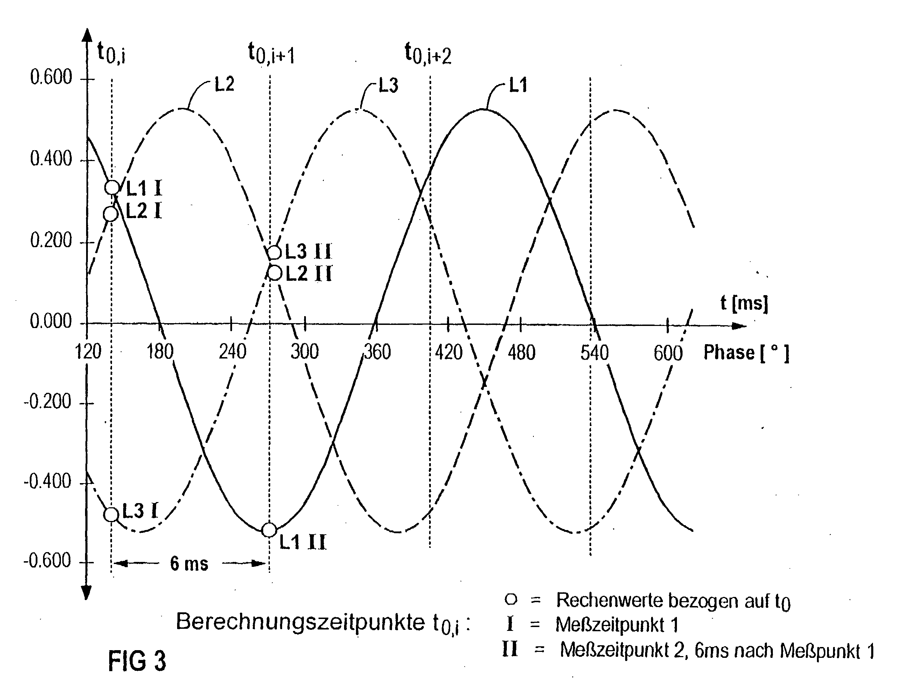

Für ein modifiziertes Verfahren der ersten Realisierung sind in Figur 3 die Signalverläufe für die einzelnen Phasen L1, L2 und L3 wiedergegeben. Es wird von der Phase L1 ausgegangen, wobei beim annähernd Dreifachen der Netzfrequenz die Signalverläufe mit einer Rechenschrittweite von jeweils 1° dargestellt sind. Für einen Zeitpunkt $t_o$ ist es möglich, jeweilige Näherungswerte zu den tatsächlichen Spannungswerten von L2 und L3 durch Interpolation zu erhalten.

Aus den gemessenen Werten und den interpolierten Näherungswerten kann unter Verwendung eines geeigneten Auswertealgorithmus eine eindeutige Aussage über einen Rechtslauf oder einen Linkslauf gemacht werden. Der selbsterklärende Auswertealgorithmus ist nachfolgend dargestellt:

Gemessen sind Meßwerte L1I, L1II, L2I, L2II, L3I, L3II von Netzspannungen in einem Drehstromnetz ($\nu_{Netz}$ = Netzfrequenz) mit einer Meßfrequenz $\nu_{Meß} \approx 3 \times \nu_{Netz}$. Dabei kennzeichnen I und II die beiden Meßzeitpunkte bzw. Meßzeitintervalle.

Erster Auswerteschritt:

1. Bestimmung der Vorzeichen der Meßwerte

sL1I = sign (L1I)
sL2I = sign (L2I)
sL3I = sign (L3I)
sL1II = sign (L1II)
sL2II = sign (L2II)
sL3II = sign (L3II)

2. Bestimmung nachfolgender Auswertediskriminante

$$\text{Wert} = |sL1I - sL1II| + |sL2I - sL2II| + |sL3I - sL3II|$$

Zweiter Auswerteschritt: Bestimmung der Drehrichtung gemäß nachfolgendem Algorithmus

```
Wenn  Wert <> 4 keine Auswertung
sonst
    Wenn sL1I - sL1II = 0
        Wenn sL1I - sL2 II = 0 und sL2 I - sL3 II = 0
            Rechtslauf
             sonst
            Linkslauf


        Ende  Wenn
    Ende  Wenn
    Wenn sL2I - sL2II = 0

        Wenn sL2I - sL3 II = 0 und sL3 I - sL1 II = 0
            Rechtslauf
             sonst
            Linkslauf
        Ende  Wenn
    Ende  Wenn
    Wenn sL3I - sL3II = 0

        Wenn sL3 I - sL1 II = 0 und sL1 I - sL2 II = 0
            Rechtslauf
             sonst
            Linkslauf
        Ende  Wenn
    Ende  Wenn
Ende Wenn
```

Wesentlich ist bei dem dargestellten Algorithmus, daß allein aus dem Vorzeichenwechsel der Drehsinn, wie "Rechtslauf" bzw. "Linkslauf" erkannt werden kann. Durch Abspeicherung eines entsprechenden Signalmusters ist eine automatisierte Entscheidung möglich.

Für die Praxis kann es von Bedeutung sein, speziell einweggleichgerichtete Drehstromsignale auszuwerten. Letzteres ist insbesondere für ein digitales Überlastrelais mit einer vorhandenen Auswerteeinheit von Bedeutung, da der dort vorhandene Analogteil der Signalerfassung nur positive Signale verarbeiten kann. Zur Drehsinnerfassung wird hierzu die zweite Realisierung eingesetzt.

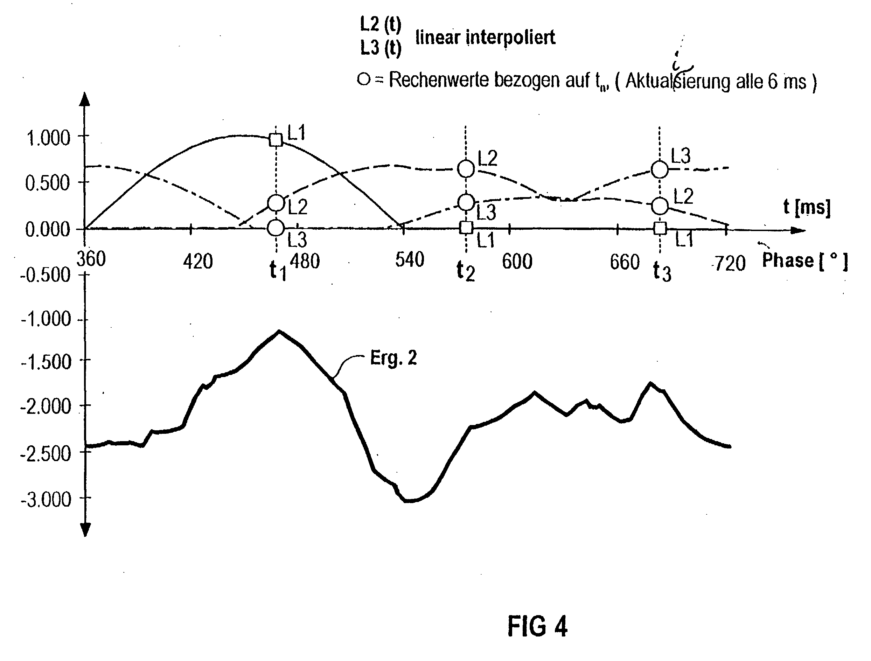

Die Signale der Verläufe der einzelnen Phasen L1 bis L3 sind in Figur 4 gleichgerichtet. Es zeigt sich, daß aus den Verläufen von einweggleichgerichteten Drehstromsignalen auch Näherungswerte durch lineare Interpolation für die Zeitpunkte tn der Phasen L2 und L3 ermittelt werden können, sofern L1 als Referenzphase betrachtet wird.

In Figur 4 ist das Ergebnis einer Gleichrichtung dargestellt. Aufgetragen sind für die gleichgerichteten Signalformen neben dem Originalsignal der Phase L1 die durch lineare Interpolation berechneten, angenäherten Verläufe der Phasen L2 und L3.

Durch ein spezifisches Berechnungsverfahrens kann der Drehsinn aus nichtidealen Sinuskurven erkannt werden. Hierzu werden mehrere aufeinanderfolgende Auswerte-Zyklen zur eindeutigen Bestimmung des Drehsinns herangezogen. Konkret bedeutet dies, daß sich ein erster Auswerte-Zyklus von Takt 1 bis Takt 3, ein zweiter Auswerte-Zyklus von Takt 2 bis Takt 4 und weitere Auswerte-Zyklen entsprechend verschoben erstrecken.

Es kann gezeigt werden, daß die Ermittlung des Drehsinns ein Auswertealgorithmus für eine Ergebnisgröße gemäß nachfolgender Gleichung signifikant ist.

Auswerte-Zyklus 1

$$Erg. = (|L1t1-L2t2|+|L1t1-L3t3|-|L1t1-L3t2|-|L1t1-L2t3|)$$

Auswerte-Zyklus 2

$$+ (|L1t2-L2t3|+|L1t2-L3t4|-|L1t2-L3t3|-|L1t2-L2t4|)$$

Auswerte-Zyklus 3

$$+ (|L1t3-L2t4|+|L1t3-L3t5|-|L1t3-L3t4|-|L1t3-L2t5|)$$

Auswerte-Zyklus 4

$$+ (|L1t4-L2t5|+|L1t4-L3t6|-|L1t4-L3t5|-|L1t4-L2t6|) \tag{2}$$

Für einen Berechnungsvorgang wird für 50 Hz/60 Hz-Netzfrequenz eine Zeitdauer von 30 ms benötigt sowie jeweils 4 ms vor dem Takt 1 und 4 ms nach dem Takt 6. Dies bedeutet, daß insgesamt 38 ms benötigt werden.

Die Anwendung der Gleichung 2 liefert ein eindeutiges Ergebnissignal zur Auswertung des Drehsinns, wobei die Ergebnisgröße zwischen den Zahlenwerten 1 und 3 für einen Linkslauf und zwischen den Zahlenwerten -1 und -3 für einen Rechtslauf bei 50 Hz Netzfrequenz und einer Relativamplitude des ursprünglichen Sinussignals von -1 bis +1 liegt. Auswirkungen von Toleranzen in der Netzspannungssymmetrie, beispielsweise Variationen zwischen 0,8 und 1,2 in der Relativamplitude der Netzspannung, und der Netzfrequenz, beispielsweise zwischen 45 und 65 Hz, sowie des Meßtaktabstandes, beispielsweise zwischen 1,7 und 2,5 ms, sind für die Drehsinnerkennung unkritisch. Diesen Grenzwerten entspricht als Taktfreqenz jeweils das Neunfache der zugehörigen Netzfrequenz. Für gebräuchliche Netze von 50/60Hz wird als praxisgerechter Mittelwert für die Taktfrequenz 500 Hz entsprechend 2 ms Taktzeit gewählt.

Zur Drehsinn-Bestimmung wird nur das Vorzeichen herangezogen:
Es gilt

$$Sign (Erg. < 0) \rightarrow Rechtslauf$$

$$Sign (Erg. > 0) \rightarrow Linkslauf$$

Eine praktische Realisierung des beschriebenen Verfahrens erfolgt zur Drehsinnerfassung eines digitalen Überlastrelais. Vorteilhaft ist dabei, daß bei üblichen digitalen Überlastrelais eine Mikroprozessoreinheit bereits vorhanden ist, da bereits eine digitale Verarbeitung von Betriebszuständen erfolgt. Diese Einheit mit den angegebenen Komponenten kann für die Drehsinnerfassung genutzt werden. Somit ist kein oder nur ein geringer weiterer zusätzlicher Hardwareaufwand erforderlich. Auf einer Anzeigeeinheit kann beim Betrieb des Überlastrelais unmittelbar "Linkslauf" oder "Rechtslauf" angezeigt werden.

Mit der Drehsinnerfassung ist beim digitalen Überlastrelais eine sinnvolle Zusatzfunktion geschaffen, da insbesondere Störfälle bei Installations- sowie Umbauarbeiten vermieden werden können.

Beim beschriebenen allgemeingültigen Verfahren liegt die Abtastfrequenz vorteilhafterweise beim Dreifachen der Netzfrequenz, wobei Abweichungen von etwa bis zu 30%, z.B. 15%, möglich sind. Für ein spezifisches Verfahren ergibt sich daraus für die alternierende Abtastfrequenz ein Wert vom Neunfachen der Abtastfrequenz.

**Patentansprüche**

1. Verfahren zur Drehsinnerkennung in Drehstromnetzen, bei dem die einzelnen Phasen zu jeweils vorbestimmten Zeitpunkten abgetastet werden, wobei die einzelnen Phasen alternierend in vorgegebenen Zeitabständen abgetastet und durch einen vorgegebenen Auswertealgorithmus ausgewertet werden, wobei der Auswertealgorithmus eine Ergebnisgröße definiert, **dadurch gekennzeichnet, daß** das Vorzeichen der Ergebnisgröße, die aus den in wenigstens zwei Zeitpunkten erhaltenen Meßwerten der einzelnen Phasen ermittelt wird, signifikant für "Linkslauf" oder "Rechtslauf" des Drehstromes ist.

2. Verfahren zur Drehsinnerkennung in Drehstromnetzen, bei dem die einzelnen Phasen zu jeweils vorbestimmten Zeitpunkten abgetastet werden, wobei die einzelnen Phasen in vorgegebenen Zeitabständen abgetastet und durch einen vorgegebenen Auswertealgorithmus ausgewertet werden, **dadurch gekennzeichnet, daß** der Auswertealgorithmus ein Muster der Vorzeichen der Meßwerte, die durch Abtastung in wenigstens zwei Zeitpunkten erhalten werden, beschreibt und daß aus der Gesamtheit der Vorzeichenänderungen der Meßwerte der einzelnen Phasen eine eindeutige Aussage "Linkslauf" oder "Rechtslauf" abgeleitet wird.

3. Verfahren nach Anspruch 2, **dadurch gekennzeichnet, daß** die einzelnen Phasen alternierend abgetastet werden.

4. Verfahren nach Anspruch 1, **dadurch gekennzeichnet, daß** bei idealem Sinusverlauf der einzelnen Phasen ein Auswertezyklus hinreichend ist.

5. Verfahren nach Anspruch 1, **dadurch gekenneichnet**, daß bei Vorliegen von Oberwellen oder Störungen mehrere Auswertezyklen gewählt werden.

6. Verfahren nach Anspruch 1, **dadurch gekennzeichnet, daß** gleichgerichtete Signalverläufe der einzelnen Phasen verwendet werden.

7. Verfahren nach Anspruch 1, **dadurch gekennzeichnet, daß** einweggleichgerichtete Signalverlaufe von einzelnen Phasen ausgewertet werden.

8. Verfahren nach Anspruch 1, **dadurch gekennzeichnet, daß** die alternierende Abtastung mit einer Frequenz erfolgt, deren Wert im Bereich vom Neunfachen der Netzfrequenz liegt.

9. Verfahren nach Anspruch 2, **dadurch gekennzeichnet, daß** die Abtastung mit einer Frequenz erfolgt, deren Wert sich von dem Dreifachen der Netzfrequenz um weniger als 30%, vorzugsweise 15%, unterscheidet.

10. Verfahren nach einem der Ansprüche 1 bis 8, **gekennzeichnet durch** die Anwendung zur Erfassung des Drehsinns im Drehstromnetz in einem digitalen Überlastrelais.

11. Verfahren nach Anspruch 10, **dadurch gekennzeichnet, daß** zur Überwachung des Drehsinns eine beim Relais bereits vorhandene digitale Signalerfassung und/oder -verarbeitung genutzt wird.

**Claims**

1. Method for sensing the direction of rotation in three-phase supply systems, in which the individual phases are each sampled at predefined points in time, where the individual phases are sampled in alternation at predefined time intervals and are evaluated by means of a predefined evaluation algorithm, where the evaluation algorithm defines a result variable, **characterised in that** the sign of the result variable which is ascertained from the measured values sampled for the individual phases at at least two points in time is significant for "anti-clockwise rotation" or "clockwise rotation" of the three-phase supply system.

2. Method for sensing the direction of rotation in three-phase supply systems, in which the individual phases are each sampled at predefined points in time, where the individual phases are sampled at predefined time intervals and are evaluated by means of a predefined evaluation algorithm, **characterised in that** the evaluation algorithm describes a pattern for the signs of the measured values which are obtained by sampling at at least two points in time, and that an unambiguous "anti-clockwise rotation" or "clockwise rotation" declaration is derived from the totality of the changes of sign for the measured values for the individual phases.

**3.** Method in accordance with Claim 2, **characterised in that** the individual phases are sampled in alternation.

**4.** Method in accordance with Claim 1, **characterised in that** in the case of an ideal sine-wave characteristic for the individual phases, one evaluation cycle is sufficient.

**5.** Method in accordance with Claim 1, **characterised in that** given the presence of harmonics or malfunctions, multiple evaluation cycles are chosen.

**6.** Method in accordance with Claim 1, **characterised in that** rectified signal waveforms for the individual phases are used.

**7.** Method in accordance with Claim 1, **characterised in that** half-wave rectified signal waveforms of individual phases are evaluated.

**8.** Method in accordance with Claim 1, **characterised in that** the alternating sampling takes place at a frequency whose value lies in the range of nine times the supply frequency.

**9.** Method in accordance with Claim 2, **characterised in that** the sampling takes place at a frequency whose value differs by less than 30%, preferably 15%, from three times the supply frequency.

**10.** Method in accordance with Claims 1 to 8, **characterised by** use for sensing the direction of rotation in the three-phase supply network in a digital overload relay.

**11.** Method in accordance with Claim 10, **characterised in that** a digital signal sensing and/or processing facility already existing in the case of the relay is used for monitoring the direction of rotation.


**Revendications**

**1.** Procédé pour la détection de sens de rotation dans des réseaux de courant triphasé, dans lequel on analyse les différentes phases à des instants respectivement prédéterminés, les différentes phases étant analysées en alternance dans des intervalles de temps prédéterminés et étant exploitées par un algorithme d'exploitation prédéterminé, l'algorithme d'exploitation définissant une grandeur de résultat, **caractérisé par le fait que** le signe de la grandeur de résultat, qui est déterminée à partir des valeurs mesurées, obtenues à deux instants au moins, des différentes phases, est significatif d'une "marche à gauche" ou d'une "marche à droite".

**2.** Procédé pour la détection de sens de rotation dans des réseaux de courant triphasé, dans lequel on analyse les différentes phases à des instants respectivement prédéterminés, les différentes phases étant analysées dans des intervalles de temps prédéterminés et étant exploitées par un algorithme d'exploitation prédéterminé, **caractérisé par le fait que** l'algorithme d'exploitation décrit un modèle des signes des valeurs mesurées qui sont obtenues par analyse à deux instants au moins et qu'on déduit de la totalité des changements de signes des valeurs mesurées des différentes phases une indication sans équivoque d'une "marche à gauche" ou d'une "marche à droite".

**3.** Procédé selon la revendication 2, **caractérisé par le fait qu'**on analyse en alternance les différentes phases.

**4.** Procédé selon la revendication 1, **caractérisé par le fait que**, dans le cas d'une allure sinusoïdale idéale des différentes phases, un cycle d'exploitation est suffisant.

**5.** Procédé selon la revendication 1, **caractérisé par le fait que**, en présence d'ondes harmoniques ou de parasites, on choisit plusieurs cycles d'exploitation.

**6.** Procédé selon la revendication 1, **caractérisé par le fait qu'**on utilise des allures de signaux redressées des différentes phases.

**7.** Procédé selon la revendication 1, **caractérisé par le fait qu'**on évalue des allures de signaux, après redressement demi-onde, de différentes phases.

**8.** Procédé selon la revendication 1, **caractérisé par le fait que** l'analyse alternée s'effectue avec une fréquence dont la valeur est de l'ordre de neuf fois la fréquence de réseau.

9. Procédé selon la revendication 2, **caractérisé par le fait que** l'analyse s'effectue avec une fréquence dont la valeur s'écarte de moins de 30 %, de préférence 15 %, du triple de la fréquence de réseau.

10. Procédé selon l'une des revendications 1 à 8, **caractérisé par** l'application pour la détection du sens de rotation dans le réseau de courant triphasé dans un relais de surcharge numérique.

11. Procédé selon la revendication 10, **caractérisé par le fait que**, pour la surveillance du sens de rotation, on utilise une détection et/ou un traitement de signal numérique déjà présent dans le relais.

TAKT 1 TAKT 2
L2 (Takt 2) = L1 (Takt 1)

TAKT 3 TAKT 1
L3 (Takt 3) = L1 (Takt 1)

FIG 1

FIG 2

Berechnungszeitpunkte $t_{0,i}$ :

FIG 3

O = Rechenwerte bezogen auf $t_0$
I = Meßzeitpunkt 1
II = Meßzeitpunkt 2, 6ms nach Meßpunkt 1

EP 0 990 162 B1

L2 (t)
L3 (t)  linear interpoliert

O = Rechenwerte bezogen auf $t_n$, ( Aktualsierung alle 6 ms )

**FIG 4**

EP 0 990 162 B1